# EUROPÄISCHE PATENTSCHRIFT

(11) **EP 3 811 437 B1**
(45) Veröffentlichungstag und Bekanntmachung des Hinweises auf die Patenterteilung: **04.03.2026**
(21) Anmeldenummer: 19732544.2
(22) Anmeldetag: 03.06.2019
(51) Int. Cl.: H01M 10/625, H01M 50/30

(54) **FAHRZEUG MIT EINEM HOCHVOLTSPEICHER**
VEHICLE WITH A HIGH-VOLTAGE ACCUMULATOR
VÉHICULE MUNI D'UN ACCUMULATEUR HAUTE TENSION

(30) Priorität: 19.06.2018 DE 102018209925
(43) Veröffentlichungstag der Anmeldung: 28.04.2021
(73) Patentinhaber: Bayerische Motoren Werke Aktiengesellschaft, 80809 München (DE)
(72) Erfinder: HUBER, Bastian, 80807 München (DE)
(86) Internationale Anmeldenummer: PCT/EP2019/064253
(87) Internationale Veröffentlichungsnummer: WO 2019/243022

(56) Entgegenhaltungen:
- EP-A1- 3 333 934
- DE-A1- 102013 021 414
- DE-A1- 102013 215 699
- DE-U1- 202012 012 670

## Beschreibung

Die vorliegende Erfindung betrifft ein Fahrzeug mit einem Speicher gemäß dem Oberbegriff des Patentanspruches 1.

Ein derartiges Fahrzeug ist aus der EP 3 333 934 A1 bekannt.

Elektrofahrzeuge bzw. Hybridfahrzeuge sind mit einem Hochvoltspeicher ausgestattet, welcher elektrische Energie zum Antreiben einer fahrzeugvortrieberzeugenden elektrischen Maschine speichert. Ein solcher Hochvoltspeicher weist ein Hochvoltspeichergehäuse auf, in dem mehrere elektrisch miteinander verschaltete Speicherzellen angeordnet sind. Um bei Schwankungen des Umgebungsluftdrucks und/oder einem Zellkurzschluss und einer damit einhergehenden Zerstörung einer oder mehrerer Speicherzellen und einer hieraus resultierenden Ausgasung von Speicherzellen einen Druckausgleich zwischen dem Inneren des Hochvoltspeichergehäuses und der Umgebung zu ermöglich, weisen Hochvoltspeichergehäuse üblicherweise, wie in der DE 10 2013 215 699 A1 gezeigt, mindestens eine Be-/Entlüftungseinrichtung auf. Über die Be-/Entlüftungseinrichtung ist ein Gasaustausch zwischen dem Inneren des Hochvoltspeichergehäuses und der Umgebung sowie ein Austritt von Kondensat aus dem Inneren des Hochvoltspeichergehäuses in die Umgebung möglich. Umgekehrt verhindert die Be-/Entlüftungsöffnung jedoch einen Eintritt von Wasser bzw. Feuchtigkeit in das Innere des Hochvoltspeichergehäuses.

Für eine ordnungsgemäße Funktion der Be-/Entlüftungseinrichtung ist es erforderlich, sicherzustellen, dass diese stets eine hinreichende Gasdurchlässigkeit aufweist.

Aufgabe der Erfindung ist es, einen Hochvoltspeicher bzw. ein Fahrzeug mit einem solchen Hochvoltspeicher zu schaffen, dessen Be-/Entlüftungseinrichtung eine erhöhte Funktionssicherheit aufweist.

Ausgangspunkt der Erfindung ist ein Fahrzeug mit einem Hochvoltspeicher, der ein Hochvoltspeichergehäuse aufweist, in dem mehrere elektrische Speicherzellen angeordnet sind. In einer Wandung des Hochvoltspeichergehäuses ist mindestens eine Be-/Entlüftungseinrichtung vorgesehen. Der Begriff "Wandung" ist äußerst breit zu verstehen. Hierbei kann es sich beispielsweise um eine obere oder untere Wandung oder eine seitliche Wandung des Hochvoltspeichergehäuses handeln. Die Be-/Entlüftungseinrichtung ist zumindest von einem Inneren des Hochvoltspeichergehäuses zu einer Außenseite bzw. zur Umgebung des Hochvoltspeichergehäuses hin gasdurchlässig (zumindest semipermeabel) und ermöglicht somit bei einem Überdruck im Inneren des Hochvoltspeichergehäuses, dass Gas aus dem Inneren des Hochvoltspeichergehäuses nach außen bzw. in die Umgebung entweichen kann und ein Druckausgleich erfolgt.

Der Kern der Erfindung besteht darin, dass an der Be- /Entlüftungseinrichtung eine Einrichtung vorgesehen ist, mittels der eine Substanz, welche sich an der Be-/Entlüftungseinrichtung ansammelt und diese teilweise oder ganz verstopft, entfernbar ist. Durch Entfernen der betreffenden Substanz mittels der Einrichtung kann eine hinreichende Gasdurchlässigkeit der Be-/Entlüftungseinrichtung sichergestellt werden.

Je nach Fahrzeugkonzept kann es nämlich erforderlich sein, die Be-/Entlüftungseinrichtung in einem Bereich des Fahrzeugs anzuordnen, in dem sich bei kalten Umgebungstemperaturen Schnee- bzw. Eis und/oder Umgebungsschmutz ansammeln kann. Bei manchen Fahrzeugkonzepten muss die Be-/Entlüftungseinrichtung beispielsweise im Bereich eines Radkastens oder im Unterbodenbereich des Fahrzeugs angeordnet werden, wo sich bei winterlichen Umgebungsbedingungen Schnee- bzw. Eis und/oder Umgebungsschmutz ansammeln kann.

Gemäß einer ersten Ausführungsform der Erfindung weist die Einrichtung, mittels der eine verstopfende Substanz entfernbar ist, eine Heizeinrichtung auf. Beispielsweise kann eine elektrische Heizeinrichtung (z. B. eine Widerstandsheizung) vorgesehen sein, mittels der die Be-/Entlüftungseinrichtung beheizbar ist. Durch Beheizen der Be-/Entlüftungseinrichtung kann Schnee oder Eis, welches bzw. welcher sich an der Be-/Entlüftungseinrichtung angesammelt hat, abgeschmolzen werden, wodurch eine teilweise oder vollständige Verstopfung der Be-/Entlüftungseinrichtung verhindert bzw. beseitigt werden kann.

Alternativ oder ergänzend zu einer elektrischen Heizeinrichtung kann die Einrichtung, mittels der die verstopfende Substanz entfernbar ist, auch einen von einem Heizmedium durchströmten Heizkanal aufweisen. Der Heizkanal kann beispielsweise an ein Heiz-/Kühlkanalsystem des Hochvoltspeichers angeschlossen sein bzw. mit diesem in Strömungsverbindung stehen. Mittels des Heiz-/Kühlkanalsystems des Hochvoltspeichers können die im Inneren des Hochvoltspeichergehäuses angeordneten Speicherzellen je nach Bedarf beheizt oder gekühlt werden.

Alternativ oder ergänzend zu einer elektrischen Heizeinrichtung oder einem Heizkanal kann die Einrichtung, mittels der die verstopfende Substanz entfernbar ist, auch einen Ultraschallerzeuger aufweisen, mit dem verstopfende Substanz wie z. B. Eis oder Umgebungsschmutz von der Be-/Entlüftungseinrichtung entfernbar ist.

Alternativ oder ergänzend zu einer elektrischen Heizeinrichtung oder einem Heizkanal oder einem Ultraschallerzeuger könnte auch eine Spritzdüse vorgesehen sein, mittels der Reinigungsflüssigkeit auf oder gegen die Be-/Entlüftungseinrichtung gespritzt und diese somit gereinigt werden kann.

Nach einer Weiterbildung der Erfindung ist vorgesehen, dass die o. g. Heizeinrichtung eingeschaltet oder ausgeschaltet werden kann und dass die Heizeinrichtung nur dann eingeschaltet ist, wenn eine an einer vorgegebenen Stelle des Fahrzeugs gemessene Temperatur kleiner als eine vorgegebene Temperatur ist. Beispielsweise kann mittels eines im Motorraum oder an anderer Stelle des Fahrzeugs angeordnete Sensoreinrichtung die Temperatur der Umgebungsluft gemessen werden. Wenn die Temperatur der Umgebungsluft eine vorgegebene Temperatur von z. B. +3°C oder +2°C oder +1°C oder 0°C unterschreitet, kann vorgesehen sein, dass die Heizeinrichtung eingeschaltet wird bzw. ist.

Außerdem ist eine Sensoreinrichtung vorgesehen, mit der detektierbar ist, ob die Be-/Entlüftungseinrichtung teilweise oder ganz durch eine verstopfende Substanz verstopft ist. Eine derartige Sensoreinrichtung kann auf einem oder mehreren Sensorprinzipien basieren. Beispielsweise kann eine Sensoreinrichtung vorgesehen sein, die auf einer elektrischen Widerstandsmessung basiert, wobei ein Sensorelement der Sensoreinrichtung einen elektrischen Widerstand aufweist, der vom Verstopfungsgrad der Be-/Entlüftungseinrichtung, d. h. von der Beladung der Be-/Entlüftungseinrichtung mit verstopfender Substanz abhängt.

Alternativ oder ergänzend dazu kann eine Sensoreinrichtung verwendet werden, die auf einer optischen Durchlässigkeitsmessung basiert, wobei die optische Durchlässigkeit der Be-/Entlüftungseinrichtung vom Verstopfungsgrad der Be-/Entlüftungseinrichtung mit verstopfender Substanz, d. h. von der Beladung der Be-/Entlüftungseinrichtung mit verstopfender Substanz abhängt.

Alternativ oder ergänzend dazu kann die Sensoreinrichtung auf dem Prinzip einer Induktivitätsänderung basieren. Eine zu überwachende Induktivität hängt dabei vom Verstopfungsgrad der Be-/Entlüftungseinrichtung mit verstopfender Substanz, d.h. von der Beladung der Be-/Entlüftungseinrichtung mit verstopfender Substanz ab.

Wie oben bereits erwähnt, betrifft die Erfindung nicht nur einen Hochvoltspeicher, sondern auch ein Fahrzeug mit einem derartigen Hochvoltspeicher.

Nach einer Weiterbildung der Erfindung ist eine Überwachungselektronik vorgesehen, die bei Überschreiten eines vorgegebenen Verstopfungsgrads der Be-/Entlüftungseinrichtung in einem Fahrgastraum des Fahrzeugs eine optische und/oder akustische Warnmeldung ausgibt. Beispielsweise kann im Kombiinstrument, in einem im Bereich der Instrumententafel vorgesehenen Displays oder einer anderen Stelle optisch eine Warnmeldung angezeigt werden, wenn die Be-/Entlüftungseinrichtung einen vorgegebenen Verstopfungsgrad überschreitet.

## Patentansprüche

1. Hochvoltspeicher, der ein Speichergehäuse aufweist, in dem mehrere elektrische Speicherzellen angeordnet sind, wobei in einer Wandung des Speichergehäuses mindestens eine Be-/Entlüftungseinrichtung vorgesehen ist, die zumindest von einem Inneren des Speichergehäuses zu einer Außenseite des Speichergehäuses hin gasdurchlässig ist, so dass bei einem Überdruck im Inneren des Speichergehäuses Gas aus dem Inneren des Speichergehäuses entweichen kann, wobei
an der Be-/Entlüftungseinrichtung eine Einrichtung vorgesehen ist, mittels der eine Substanz, welche sich an der Be-/Entlüftungseinrichtung ansammelt und diese teilweise oder ganz verstopft, entfernbar ist, wobei die Einrichtung eine Heizeinrichtung und/oder
einen Ultraschallerzeuger aufweist, mit der oder mit dem sich an der Be-/Entlüftungseinrichtung angesammelte verstopfende Substanz entfernbar ist;
**dadurch gekennzeichnet, dass**
eine Sensoreinrichtung vorgesehen ist, mit der detektierbar ist, ob die Be-/Entlüftungseinrichtung teilweise oder ganz durch Schnee oder Eis und/oder Umgebungsschmutz verstopft ist, wobei die Sensoreinrichtung eine
- auf einer elektrischen Widerstandsmessung basierende Sensoreinrichtung ist, wobei der zu messende Widerstand von dem Verstopfungsgrad der Be-/Entlüftungseinrichtung abhängt und/oder
- auf einer optischen Durchlässigkeitsmessung basierende Sensoreinrichtung ist, wobei die optische Durchlässigkeit der Be-/Entlüftungseinrichtung von dem Verstopfungsgrad der Be-/Entlüftungseinrichtung abhängt, und/oder
- eine auf einer Induktivitätsmessung basierende Sensoreinrichtung ist, wobei eine zu überwachende Induktivität von dem Verstopfungsgrad der Be-/Entlüftungseinrichtung abhängt.

2. Hochvoltspeicher nach Anspruch 1, **dadurch gekennzeichnet, dass** die Substanz zu Eis oder Schnee gefrorenes Wasser und/oder Umgebungsschmutz ist.

3. Hochvoltspeicher nach Anspruch 1 oder 2, **dadurch gekennzeichnet, dass** die Heizeinrichtung eine elektrische Heizeinrichtung ist oder eine elektrische Heizeinrichtung aufweist, mittels der die Be-/Entlüftungseinrichtung beheizbar ist, wodurch sich dort angesammelter Schnee oder dort angesammeltes Eis abschmelzbar ist.

4. Hochvoltspeicher nach Anspruch 1, 2 oder 3, **dadurch gekennzeichnet, dass** die Heizeinrichtung mindestens einen von einem Heizmedium durchströmten Heizkanal aufweist.

5. Hochvoltspeicher nach Anspruch 4, **dadurch gekennzeichnet, dass** der Heizkanal mit einem Heiz-/Kühlkanalsystem des Hochvoltspeichers in Strömungsverbindung steht.

6. Hochvoltspeicher nach einem der Ansprüche 1 bis 5, **dadurch gekennzeichnet, dass** die Heizeinrichtung eingeschaltet oder ausgeschaltet werden kann und nur dann eingeschaltet ist, wenn eine an einer vorgegebenen Stelle gemessene Temperatur kleiner als eine vorgegebene Temperatur ist.

7. Fahrzeug mit einem Hochvoltspeicher nach einem der Ansprüche 1 bis 6.

8. Fahrzeug nach Anspruch 7, **dadurch gekennzeichnet, dass** eine Überwachungselektronik vorgesehen ist, die bei Überschreiten eines vorgegebenen Verstopfungsgrads der Be-/Entlüftungseinrichtung in einem Fahrgastraum des Fahrzeugs eine optische und oder akustische Warnmeldung ausgibt.

## Claims

1. High-voltage storage device, which has a storage housing in which a plurality of electrical storage cells are arranged, wherein in a wall of the storage housing at least one ventilation device is provided, which is gas-permeable at least from an interior of the storage housing to an outside of the storage housing, so that in the event of an overpressure in the interior of the storage housing gas can escape from the interior of the storage housing, wherein on the ventilation device a device is provided, by means of which a substance, which accumulates at the ventilation device and partially or completely clogs it, is removable, wherein
the device comprises a heating device and/or
an ultrasonic generator, with which or with which substance accumulated at the ventilation device and causing clogging is removable;
**characterised in that**
a sensor device is provided, with which it is detectable whether the ventilation device is partially or completely clogged by snow or ice and/or environmental dirt, wherein the sensor device is a
- sensor device based on an electrical resistance measurement, wherein the resistance to be measured depends on the degree of clogging of the ventilation device and/or
- sensor device based on an optical transmission measurement, wherein the optical transmission of the ventilation device depends on the degree of clogging of the ventilation device, and/or
- sensor device based on an inductance measurement, wherein an inductance to be monitored depends on the degree of clogging of the ventilation device.

2. High-voltage storage device according to claim 1, **characterised in that** the substance is water frozen to ice or snow and/or environmental dirt.

3. High-voltage storage device according to claim 1 or 2, **characterised in that** the heating device is an electrical heating device or comprises an electrical heating device, by means of which the ventilation device is heatable, whereby snow or ice accumulated there is meltable.

4. High-voltage storage device according to claim 1, 2 or 3, **characterised in that** the heating device comprises at least one heating channel through which a heating medium flows.

5. High-voltage storage device according to claim 4, **characterised in that** the heating channel is in flow connection with a heating/cooling channel system of the high-voltage storage device.

6. High-voltage storage device according to one of claims 1 to 5, **characterised in that** the heating device can be switched on or switched off and is only switched on when a temperature measured at a predetermined location is lower than a predetermined temperature.

7. Vehicle with a high-voltage storage device according to one of claims 1 to 6.

8. Vehicle according to claim 7, **characterised in that** a monitoring electronics is provided, which, when a predetermined degree of clogging of the ventilation device is exceeded, outputs an optical and or acoustic warning message in a passenger compartment of the vehicle.

## Revendications

1. Accumulateur haute tension, qui présente un boîtier d'accumulateur dans lequel sont disposées plusieurs cellules d'accumulation électriques, dans lequel dans une paroi du boîtier d'accumulateur est prévu au moins un dispositif de ventilation, qui est perméable aux gaz au moins depuis un intérieur du boîtier d'accumulateur vers un côté extérieur du boîtier d'accumulateur, de sorte qu'en cas de surpression à l'intérieur du boîtier d'accumulateur du gaz peut s'échapper de l'intérieur du boîtier d'accumulateur, dans lequel sur le dispositif de ventilation est prévu un dispositif, au moyen duquel une substance, qui s'accumule au niveau du dispositif de ventilation et l'obstrue partiellement ou complètement, est amovible, dans lequel le dispositif comprend un dispositif de chauffage et/ou
un générateur d'ultrasons, avec lequel ou avec lequel une substance obstruante accumulée au niveau du dispositif de ventilation est amovible ;
**caractérisé en ce que**
un dispositif de capteur est prévu, avec lequel il est détectable si le dispositif de ventilation est partiellement ou complètement obstrué par de la neige ou de la glace et/ou de la saleté ambiante, dans lequel le dispositif de capteur est un
- dispositif de capteur basé sur une mesure de résistance électrique, dans lequel la résistance à mesurer dépend du degré d'obstruction du dispositif de ventilation et/ou
- dispositif de capteur basé sur une mesure de transmission optique, dans lequel la transmission optique du dispositif de ventilation dépend du degré d'obstruction du dispositif de ventilation, et/ou
- dispositif de capteur basé sur une mesure d'inductance, dans lequel une inductance à surveiller dépend du degré d'obstruction du dispositif de ventilation.

2. Accumulateur haute tension selon la revendication 1, **caractérisé en ce que** la substance est de l'eau gelée en glace ou en neige et/ou de la saleté ambiante.

3. Accumulateur haute tension selon la revendication 1 ou 2, **caractérisé en ce que** le dispositif de chauffage est un dispositif de chauffage électrique ou comprend un dispositif de chauffage électrique, au moyen duquel le dispositif de ventilation est chauffable, moyennant quoi de la neige ou de la glace accumulée là est fusible.

4. Accumulateur haute tension selon la revendication 1, 2 ou 3, **caractérisé en ce que** le dispositif de chauffage comprend au moins un canal de chauffage traversé par un milieu de chauffage.

5. Accumulateur haute tension selon la revendication 4, **caractérisé en ce que** le canal de chauffage est en communication d'écoulement avec un système de canaux de chauffage/refroidissement de l'accumulateur haute tension.

6. Accumulateur haute tension selon l'une des revendications 1 à 5, **caractérisé en ce que** le dispositif de chauffage peut être mis en marche ou arrêté et n'est mis en marche que lorsqu'une température mesurée à un emplacement prédéterminé est inférieure à une température prédéterminée.

7. Véhicule avec un accumulateur haute tension selon l'une des revendications 1 à 6.

8. Véhicule selon la revendication 7, **caractérisé en ce qu'**une électronique de surveillance est prévue, qui, lors du dépassement d'un degré d'obstruction prédéterminé du dispositif de ventilation, émet un message d'avertissement optique et ou acoustique dans un habitacle du véhicule.
